(19) **Europäisches Patentamt** / **European Patent Office** / **Office européen des brevets**

(11) **EP 4 564 517 A1**

(12) # EUROPEAN PATENT APPLICATION

(43) Date of publication:
**04.06.2025 Bulletin 2025/23**

(21) Application number: **24215749.3**

(22) Date of filing: **27.11.2024**

(51) International Patent Classification (IPC):
**H01M 10/42** (2006.01)   **H01M 10/48** (2006.01)
**G01K 7/00** (2006.01)   **G01L 1/18** (2006.01)

(52) Cooperative Patent Classification (CPC):
**H01M 10/425; G01K 7/00; G01L 1/18; H01M 10/48;
H01M 10/482; H01M 10/486;** H01M 2010/4271;
H01M 2220/20

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **30.11.2023 EP 23213351**

(71) Applicant: **Volvo Truck Corporation
405 08 Göteborg (SE)**

(72) Inventors:
• **Choi, YoungJin
421 73 Västra Frölunda (SE)**
• **Tintignac, Sophie
418 71 Göteborg (SE)**
• **Ahmed, Istaq
422 44 Göteborg (SE)**

(74) Representative: **Valea AB
Box 1098
405 23 Göteborg (SE)**

(54) **A METHOD OF DETERMINING PRESSURE AND TEMPERATURE OF AN ELECTRICAL DEVICE**

(57)    The present disclosure relates to a computer-implemented method of determining more than one operating parameter of an electrical device by means of a multi-parameter sensing film (200, 300). It also relates to a battery cell comprising the sensing film. The sensing film comprises:
- a substrate (201,301),
- one or more sensing elements (210, 310a-310d) arranged on said substrate, wherein said one or more sensing elements are formed by one single responsive material which is configured to exhibit changes in electrical resistance in response to changes in said operating parameters,
- a plurality of monitoring circuits (204a-204d, 304a-304d) arranged at predefined monitoring positions (202a-204d, 302a-302d) that are spaced apart from each other over said substrate, said monitoring circuits being configured to monitor the electrical resistance of said one single responsive material at monitoring positions,
the method comprising:
- detecting (S1) electrical resistance of said responsive material at monitoring positions, and
- determining (S2) the operating parameters at said monitoring positions by using information of the detected electrical resistance.

Fig. 3a

**Description**

**TECHNICAL FIELD**

The disclosure relates generally to parameters detection of an electrical device. In particular aspects, the disclosure relates to a method for detecting more than one operating parameters of an electrical device by use of a sensing film. Furthermore, a battery module and a battery system comprising the sensing film are also provided. The battery module and/or the battery system may be installed in vehicles, which can be applied to heavy-duty vehicles, such as trucks, buses, and construction equipment, among other vehicle types. Although the disclosure may be described with respect to a particular vehicle, the disclosure is not restricted to any particular vehicle.

**BACKGROUND**

It is known that monitoring of operating parameters of an electrical device, such as operating parameters of a battery module, is important for enhancing safety, optimizing performance, and ensuring a prolonged lifespan of the battery module. It may allow for early fault detection, enable proactive implementation of preventive measures, and provide an input on the overall health of the battery module.

Various solutions exist for assessing the overall health of battery modules. For example, temperature sensors are commonly employed to monitor the temperature of battery cells. Typically, the temperature sensors are placed on the top plate or positive/negative terminals of the battery cells due to limited spaces in a battery module. However, to be able to obtain comprehensive temperature information in the battery module, multiple temperature sensors are needed to be placed at different locations in the battery module, which is neither cost-efficient nor space- efficient. Furthermore, the temperature sensors are not able to detect other critical operating parameters that have impact on battery health, such as changes in pressure, which may be indicative of cell swelling.

Therefore, there is a strive to develop improved technology for detecting operating parameters of an electrical device.

SUMMARY

According to a first aspect of the disclosure, a computer-implemented method of determining more than one operating parameter of an electrical device comprising at least one surface according to claim 1 is provided. The method is performed by means of a multi-parameter sensing film, which is arranged to be abutted against the surface of the electrical device. The more than one operating parameter is temperature and pressure. The film comprises:

- a substrate,
- one or more sensing elements arranged on the substrate, wherein the one or more sensing elements are formed by one single responsive material which is configured to exhibit changes in electrical resistance in response to changes in the operating parameters,
- a plurality of monitoring circuits arranged at predefined monitoring positions that are spaced apart from each other over the substrate, the monitoring circuits being configured to monitor the electrical resistance of the one single responsive material at the predefined monitoring positions,

the method comprises:

- detecting, by processing circuitry of a computer system, electrical resistance of the responsive material at the predefined monitoring positions, and
- determining, by the processing circuitry, the operating parameters at the monitoring positions by using information of the detected electrical resistance.

The first aspect of the disclosure may seek to provide an improved method which may detect temperature and pressure in local areas of the surface of an electrical device. A technical benefit may include that it provides more comprehensive information for assessing the overall health state of the electrical device. Furthermore, it may eliminate the need to use multiple sensors for obtaining such information, thus reducing cost and space demands.

The technical benefit is achieved by use of the multi-parameter sensing film that comprises one or more sensing elements formed by one single responsive material and a plurality of monitoring circuits arranged at various monitoring positions. The electrical resistance of the responsive material may generally increase or decrease with an increased temperature and pressure. Thanks to this material property, it may be possible to assess the temperature and pressure changes at local monitoring positions by using information of the detected electrical resistance, and thereby to possibly obtain a temperature and pressure distribution profile across the entire sensing film, which, in turn, may reflect the temperature and pressure distribution profile across the mirroring surface of the electric device when the film is abutted against the surface of the electrical device. In this way, it may be possible to identify localized issues at the electrical device, such as hotspots or pressure spikes.

Herein, the 'one single responsive material' may refer to a substance that is homogeneous and is made from the same type of material, either pure material or a composite material. Moreover, the material may comprise a single-layered structure or may comprise a layered structure, and may be composed of a uniform substance or a uniform mix of substances with identical chemical composition(s) and properties across the entire structure. Additionally, by 'one single' it means that the same pure material or the same composite material are used as the responsive material throughout the substrate. The monitoring circuits may measure the electrical resistance of the responsive material and convert it into sensing data. By using one responsive material, it may not only simplify the sensing film's configuration and manufacturing process, but also may simplify a subsequent data process.

Optionally in some examples, including in at least one preferred example, the one single responsive material comprises one of the following: graphene, graphene oxides, carbon nano tubes, carbon nano fibers, graphite embedded polydimethylsiloxane, or poly(3,4-ethylenedioxythiophene) polystyrene sulfonate.

Optionally in some examples, including in at least one preferred example, the method further comprising:

- determining, by the processing circuitry, the more than one operating parameter by converting the electrical resistance detected at the monitoring positions to the corresponding values.

The electrical resistance may be converted by using mathematical models which illustrate a correlation between electrical resistance of the responsive material and temperature or pressure. This may allow for the precise determination of temperature and pressure values. A technical benefit may be a substantial enhancement of accuracy in temperature and pressure measurement.

Optionally in some examples, including in at least one preferred example, the method comprises:

- defining, by the processing circuitry, the operating parameter(s) to be monitored at each monitoring position, and
- converting, by the processing circuitry, the electrical resistance detected at each monitoring position to the defined operating parameter value (s).

For different electrical devices, the monitoring of the operating parameters can vary significantly based on the various factors, for example, depending on applications of the electrical device and operational conditions. The significance of monitoring temperature might be vital in certain regions of the electrical device, while pressure measurement may take precedence elsewhere. By defining the operating parameter(s) to be monitored at each monitoring position, it may allow for the precise delineation of areas of interest, enabling the tailored selection of parameters for monitoring at these specific points. In this way, it may ensure that the monitoring process aligns precisely with the device's unique needs. A technical benefit may include that a more adaptable and efficient monitoring method is achieved.

Optionally in some examples, including in at least one preferred example, the electrical device is a battery cell comprised in a battery system of a vehicle, the battery system further comprising a battery management unit configured to monitor the more than one operating parameter of the battery cell by using information of the electrical resistance detected at monitoring positions, the method further comprising:

- in response to the determined more than one operating parameter being higher than an upper threshold level and/or being lower than a lower threshold level, issuing, by processing circuitry of the battery management unit, a warning signal to a vehicle ECU.

In some examples, the warning signal may be issued when the temperature and/or the pressure at one monitoring position is higher than an upper threshold level. In some other examples, the warning signal may be issued when the temperature and/or the pressure at a number of monitoring positions is higher than a threshold level. The threshold level may vary in different monitoring positions, which may allow for dynamic adaptation, as the threshold levels can be tailored to each monitoring position, enhancing the precision of the system's warnings. A technical benefit may include that critical issues are addressed promptly, preventing potential damage or accidents in the battery system.

According to a second aspect of the disclosure, a battery cell according to claim 6 is provided. The battery cell comprises:

- at least one surface,
- one or more multi-parameter sensing films arranged to be abutted against the surface of the battery cell, the film at least partially or fully covering the surface of the battery cell,

- wherein the multi-parameter sensing film comprises:
- a substrate,
- one or more sensing elements arranged on the substrate, wherein the one or more sensing elements are formed by one single responsive material which is configured to exhibit changes in electrical resistance in response to changes in more than one operating parameter of the battery cell, wherein the more than one operating parameter is temperature and pressure,
- a plurality of monitoring circuits arranged at predefined monitoring positions that are spaced apart from each other over the substrate, the monitoring circuits being configured to monitor the electrical resistance of the one single responsive material at the predefined monitoring positions,

The second aspect of the disclosure may seek to provide an improved battery cell in which temperature and pressure in local areas of the surface of the battery cell is monitored. A technical benefit may include that it provides more comprehensive information for assessing the overall health state of the battery cell. Furthermore, it may eliminate the need to use multiple sensors in the battery cell for obtaining such information, thus reducing cost and space demands.

The technical benefit is achieved by use of the multi-parameter sensing film that comprises one or more sensing elements formed by one single responsive material and a plurality of monitoring circuits arranged at various monitoring positions. The electrical resistance of the response material may generally increase or decrease with an increased temperature and pressure. Thanks to this material property, it may be possible to assess the temperature and pressure changes at local monitoring positions by using information of the detected electrical resistance, and thereby possibly obtaining a temperature and pressure distribution profile across the entire sensing film, which, in turn, may reflect the temperature and pressure distribution profile across the mirroring surface of the battery cell. In this way, it may be possible to identify localized issues or variations, such as hotspots or pressure spikes due to cell swelling.

The monitoring positions may vary in terms of distribution. In some examples, these monitoring positions may be evenly distributed, spaced to cover the substrate uniformly. The even distribution may ensure that each area of the substrate receives consistent monitoring, which can be advantageous for applications requiring uniform data collection or when maintaining an equilibrium across the battery cell is crucial. In some other examples, the monitoring positions may be unevenly distributed, which may serve purposes such as focusing monitoring on particular areas of interest.

Optionally in some examples, including in at least one preferred example, the one single responsive material comprises one of the following: graphene, graphene oxides, carbon nano tubes, carbon nano fibers, graphite embedded polydimethylsiloxane, or poly (3,4-ethylenedioxythiophene) polystyrene sulfonate. Each one of the aforementioned materials may exhibit a unique sensitivity to temperature and pressure, which may determine its specific detection range. The operating temperature and pressure can vary depending on the type of battery cell, influencing its preferred detection range. An appropriate response material may be selected based on the specific type of battery cell, or the preferred detection range of the temperature and pressure.

Optionally in some examples, including in at least one preferred example, the sensing elements are formed at the predefined monitoring positions. In this way, individual sensing elements are less susceptible to interference from neighboring regions. A technical benefit may include improved accuracy in detecting parameters in the local area.

Optionally in some examples, including in at least one preferred example, each sensing element has a defined shape with a defined dimension. Generally, battery cells may vary in sizes and/or shapes, depending on the intended applications. By allowing the shape and dimension of each sensing element to vary, the multi-parameter sensing film may adapt to the specific characteristics of different battery cells. Furthermore, to accurately monitor changes in temperature and pressure within a battery cell, it may be crucial that the sensing elements fit precisely within the designated monitoring positions. Having defined shapes and dimensions may ensure a consistent and precise fit. A technical benefit may include improved adaptability, and improved precision in monitoring.

Optionally in some examples, including in at least one preferred example, each monitoring position is defined to monitor one of the following: temperature, or pressure, or both temperature and pressure. The significance of monitoring temperature might be vital in certain regions of the battery cell, while pressure measurement may take precedence elsewhere. By defining the operating parameter(s) to be monitored at each monitoring position, it may allow for the precise delineation of areas of interest, enabling the tailored selection of parameters for monitoring at these specific points. A technical benefit may include that more efficient monitoring is achieved.

Optionally in some examples, including in at least one preferred example, for the monitoring positions that are defined to monitor both temperature and pressure, the sensing elements are formed by two layers of the single one responsive material arranged on top of each other. In these examples, the sensing elements may further comprise an additional insulation layer sandwiched between the two layers of the responsive material. As such, one layer may be configured to detect pressure, and another layer may be configured to detect temperature at the same monitoring position. Accordingly, each one of the layers may be provided with its own monitoring circuit.

Optionally in some examples, including in at least one preferred example, the substrate is formed by a polymer-based material Purely by way of example, the polymer-based material may be one of, or a combination of, polyethylene terephthalate, polydimethylsiloxane, or polyimide. As such, the multi-parameter sensing film may easily conform to the contours and shapes of different battery cells due to the factor that polymer materials may have flexibility and pliability. This flexibility may allow the sensing film to adhere to the surface of battery cells, ensuring maximum contact and coverage and maintaining consistent contact across the battery surface, thereby to optimize the effectiveness of the monitoring of the parameters. A technical benefit may include an improved effectiveness of the monitoring of the parameters.

Optionally in some examples, including in at least one preferred example, the substrate has a thickness less than 1mm. As such, the thermal management film may have an ultra-thin profile, which may allow the film to be used in electrical devices with limited space.

According to a third aspect of the disclosure, a battery module according to claim 13 is provided. The battery module comprises a plurality of battery cells according to any example of the second aspect of the disclosure.

Optionally in some examples, including in at least one preferred example, the battery cells are cylindrical batteries, and wherein the cylindrical batteries are stacked adjacent to one another in a side-by-side configuration to form one or more battery stack.

Optionally in some examples, including in at least one preferred example, one multi-parameter sensing film is arranged to be wrapped around the battery stack, such that the sensing film at least partially covers each one battery cell of the battery stack, or wherein each battery cell is provided with one multi-parameter sensing film. In this way, the temperature and pressure at each battery cell may be monitored. A technical benefit may include that it provides more comprehensive information for assessing the overall health state of the battery module.

Optionally in some examples, including in at least one preferred example, the battery cells are prismatic batteries or pouch batteries, and wherein the battery cells are stacked adjacent to one another in a side-by-side configuration.

Optionally in some examples, including in at least one preferred example, the multi-parameter sensing film is sandwiched between the adjacent battery cells. In this way, the temperature and pressure at each battery cell are monitored. A technical benefit may include that it provides more comprehensive information for assessing the overall health state of the battery module.

According to a fourth aspect of the disclosure, a battery system comprising the battery module according to the third aspect, and a battery management unit is provided. The battery management unit is configured to monitor the more than one operating parameter at defined areas of the at least one surface of the battery cell by using information of the electrical resistance detected at monitoring positions. For instance, the battery management unit may be a computer system comprising processing circuitry which maybe communicatively connected to the monitoring circuits.

According to a fifth aspect of the disclosure, a vehicle comprising a battery module according to the third aspect of the disclosure and/or a battery system according to the fourth aspect is provided.

The disclosed aspects, examples (including any preferred examples), and/or accompanying claims may be suitably combined with each other as would be apparent to anyone of ordinary skill in the art. Additional features and advantages are disclosed in the following description, claims, and drawings, and in part will be readily apparent therefrom to those skilled in the art or recognized by practicing the disclosure as described herein.

## BRIEF DESCRIPTION OF THE DRAWINGS

Examples are described in more detail below with reference to the appended drawings.

**FIG. 1** is an exemplary embodiment of the present disclosure, comprising a multi-parameter sensing film, according to an example.

**FIG. 2** is a flow-chart illustrating steps of a method for detecting more than one operating parameter of an electrical device by use of the multi-parameter sensing film of **FIG. 1.**

**FIG. 3a-3d** shows several exemplary multi-parameter sensing film according to a number of examples.

**FIG. 3e** shows an example where for the monitoring positions are defined to monitor both temperature and pressure.

**FIG. 4** is a battery cell comprising a multi-parameter sensing film being abutted against one surface of the battery cell, according to an example.

**FIG. 5** is a battery module comprising a plurality of battery cells of **FIG.4,** according to an example.

**FIG. 6** is a battery cell comprising a multi-parameter sensing film being abutted against one surface of the battery cell, according to another example.

**FIG. 7** is a battery module comprising a plurality of battery cells of **FIG.6,** according to another example.

**FIG. 8a and FIG. 8b** are a top view and a side view of a battery module comprising a plurality of battery cells of **FIG.6,** according to yet another example.

**FIG. 8c and FIG. 8d** are a top view and a side view of a battery module comprising a plurality of battery cells of FIG.6, according to yet another example.

**FIG. 9** is a vehicle, in the form of a truck, comprising a battery system and a battery module, according to an example.

**FIG. 10** is a schematic diagram of an exemplary computer system for implementing examples disclosed herein, in accordance with an example of the present disclosure.

**DETAILED DESCRIPTION**

Monitoring of operating parameters of an electrical device, such as a battery module, is important for enhancing safety, optimizing performance, and ensuring a prolonged lifespan of the battery module. It may allow for early fault detection, enable proactive implementation of preventive measures, and provide an input on the overall health of the battery module.

The present disclosure may seek to provide an improved method which may detect temperature and pressure at local areas of a surface of an electrical device. The present disclosure also relates to an improved battery cell in which temperature and pressure at local areas of a surface of the battery cell is monitored. A technical benefit may include that it provides more comprehensive information for assessing the overall health state of the electrical device and the battery cell. Furthermore, it may eliminate the need to use multiple sensors for obtaining such information, thus reducing cost and space demands.

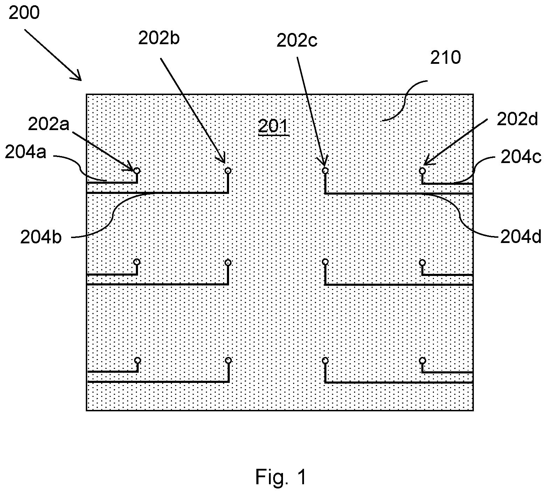

**FIG. 1** is a schematic view of a multi-parameter sensing film 200 according to an example.

The multi-parameter sensing film 200 comprises a substrate 201, where one sensing element 210 is arranged on the substrate 201 and a plurality of monitoring circuits 204a-204d are arranged at predefined monitoring positions 202a-202d that are spaced apart from each other over the substrate 201. The substrate 201 may be formed by a polymer-based material, which may exhibit high adaptability to various electrical devices' contours and shapes thanks to the flexibility and pliability of polymer materials. Purely by way of example, the polymer-based material may be one of, or a combination of, polyethylene terephthalate, polydimethylsiloxane, or polyimide. Moreover, the substrate may have a thickness less than 1 mm. As such, the multi-parameter sensing film 200 may have an ultra-thin profile.

In the illustrated example, the sensing element 210 is formed by one single responsive material which is configured to exhibit changes in electrical resistance in response to changes in temperature and pressure. Purely by way of example, the responsive material may comprise one of the following: graphene, graphene oxides, carbon nano tubes, carbon nano fibers, graphite embedded polydimethylsiloxane, or poly(3,4-ethylenedioxythiophene) polystyrene sulfonate. Moreover, the monitoring circuits 204a-204d are arranged at the predefined monitoring positions 202a-202d over the substrate 201 and are configured to detect electrical resistance of the responsive material at these positions 202a-202d. The monitoring circuits 204a-204d may measure the electrical resistance of the responsive material and convert the measured electrical resistance into a digital signal or data. Generally, the electrical resistance of the responsive material has a relationship with the temperature and pressure. For instance, the electrical resistance of the responsive material may increase with an increased temperature, and may decrease with an increased pressure, and vice versa. Due to this material property, it may be possible to determine the temperature and pressure at each one of the monitoring positions 202a-202d by using the information of detected electrical resistance of the responsive material at these positions 202a-202d. Thereafter, it may be possible to obtain a temperature and pressure distribution profile across the entire multi-parameter sensing film 200. When the multi-parameter sensing film 200 is abutted against a surface of an electrical device, the obtained temperature and pressure distribution profile may reflect a temperature and pressure distribution profile across the mirroring surface of the electrical device.

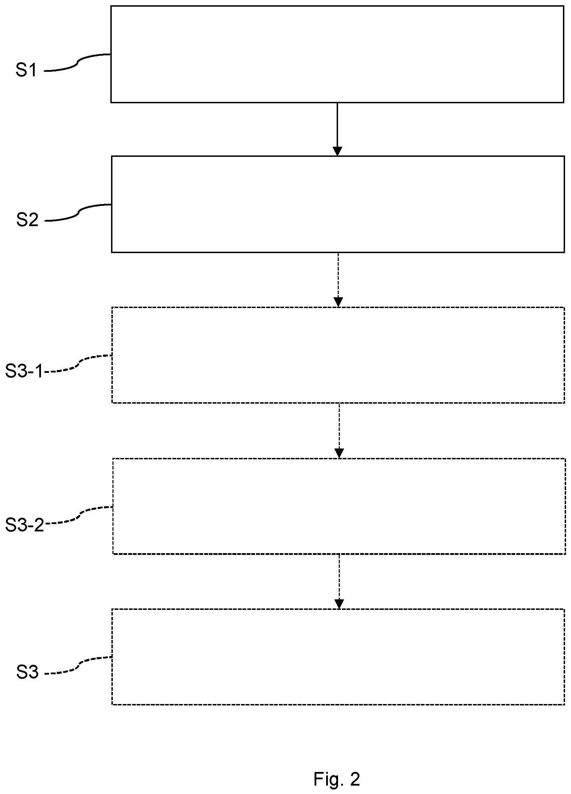

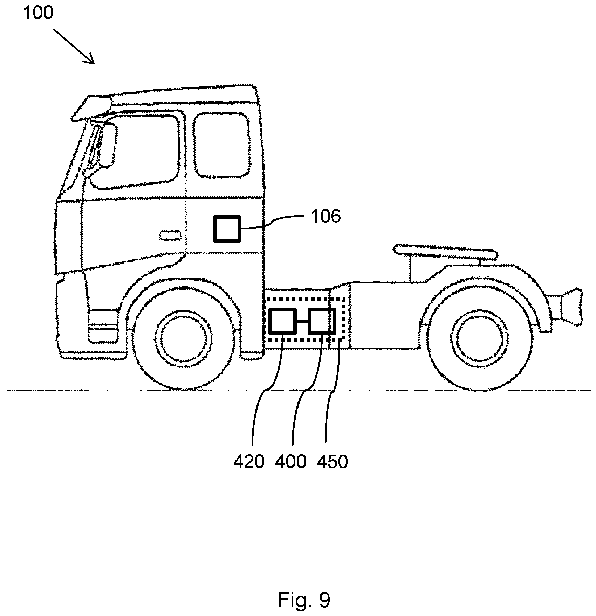

**FIG. 2** is a flow-chart illustrating steps of a method for detecting more than one operating parameter of an electrical device by use of the multi-parameter sensing film 200 of **FIG. 1.** The method comprises the steps listed in the following, which, unless otherwise indicated, may be taken in any suitable order. The method may be performed when the multi-parameter sensing film 200 is abutted against a surface of an electrical device. The method is a computer-implemented method, and is performed by processing circuitry 402 of a computer system 400 shown in **FIG. 9.** The processing circuitry 402 may be communicatively connected to the monitoring circuits 204a-204d.

**S1:** detecting, by the processing circuitry 402, the electrical resistance of the one single responsive material at the predefined monitoring positions 202a-204d, 302a-302d, and

**S2:** determining, by the processing circuitry 402, the more than one operating parameter at the monitoring positions 202a-204d, 302a-302d by using information of the detected electrical resistance. As mentioned above, due to the material property of the responsive material, the detected electrical resistance may indicate changes in temperature and pressure at these monitoring positions 202a-202d. As such, it may be possible to obtain a temperature distribution profile and a pressure distribution profile across the entire multi-parameter sensing film 200 based on the detected electrical resistance, which may reflect the temperature and pressure distribution across the mirroring surface of the electrical device.

In some examples, it may be sufficient to obtain a trend of temperature and pressure change by evaluating the changes in the electrical resistance without converting it to any actual value. In some other examples, it may be advantageous to obtain a specific value for precise determination of the parameters. In these examples, the method may comprise an optional step S3: determining the more than one operating parameter by converting the electrical resistance detected at the monitoring positions 202a-204d, 302a-302d to the corresponding parameter values.

In these examples, mathematical models, which illustrate a correlation between electrical resistance and temperature, or pressure, may be used. Purely by way of example, the following equation, cited in Jiri Štulík et al. Nanomaterials 2022, 12, 1594, may be used for determining the parameter of temperature:

$$TCR = \frac{1}{R_0} \cdot \frac{R - R_0}{T - T_0} \qquad (1)$$

where TCR is the temperature coefficient of resistance of a responsive material, $R_0$ is an initial electrical resistance of the responsive material at the initial temperature $T_0$ (10 °C) and R is the electrical resistance of the responsive material at temperature T (100 °C).

Furthermore, the below equation, cited in Gold sensing array, Sara S. Mechael et al. iScience 24, 102525, June 25, 2021, describes a relationship between mechanical strain and an electrical resistance of the responsive material.

$$GF = \frac{R - R_0}{\varepsilon} \qquad (2)$$

where GF is defined as the change in resistance in response to strain, and where R is electrical resistance of the responsive material, $R_0$ is the initial resistance of the responsive material, and $\varepsilon$ is the mechanical strain. The mechanical strain may then be used to determine the pressure over the responsive material.

It shall be noted that the above equations are just examples to illustrate how to convert the obtained electrical resistance to temperature and pressure values. There are numerous established mathematical equations and methods for performing these conversions. These equations are well-documented and widely recognized in the field, and thus are not discussed in detail herein.

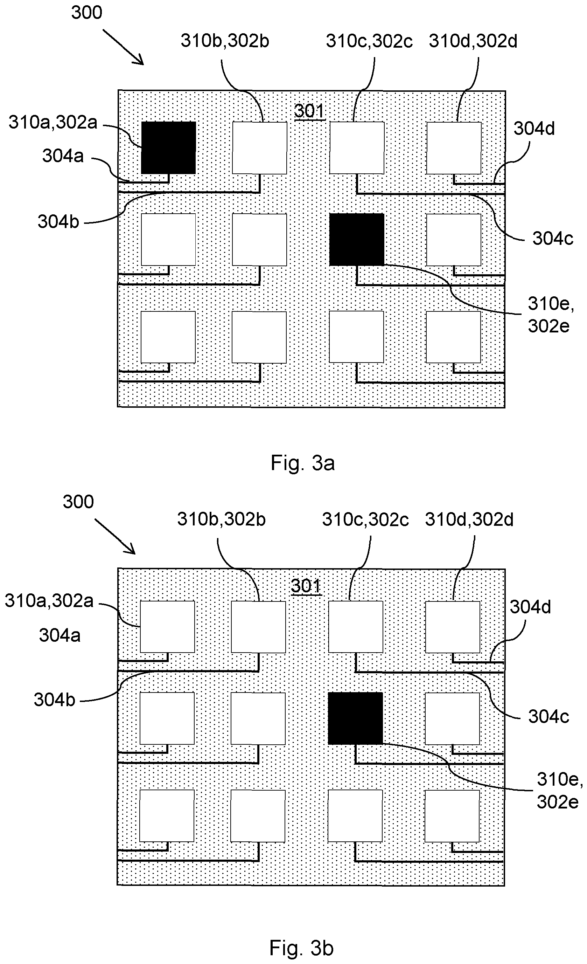

The optional step S3 may further comprise optional steps **S3-1, S3-2.** These steps may be performed by use of a multi-parameter sensing film 300 according to another example shown in **FIG. 3a-3d.** Therefore, the following optional steps will be explained along with **FIG. 3a-3d.**

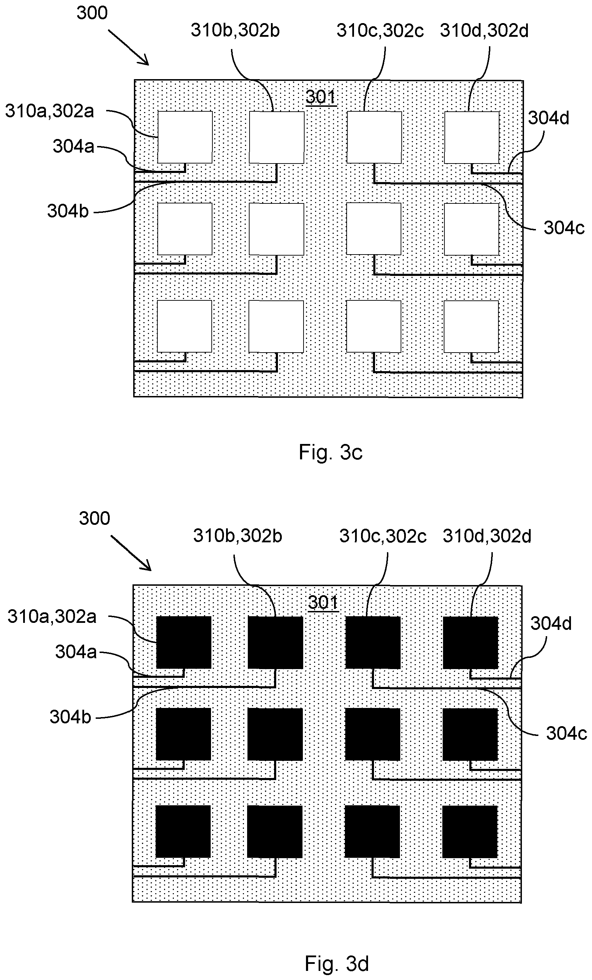

**FIG. 3a-3d** show various examples of the multi-parameter sensing film 300 where the parameter to be monitored at each monitoring position 302a-302e can be defined. The multi-parameter sensing film 300 comprises sensing elements 310a-310e arranged on a substrate 301 and a plurality of monitoring circuits 304a-304d arranged at predefined monitoring positions 302a-302e that are spaced apart from each other over the substrate 301. In the example of **FIG. 3a,** the predefined monitoring position 310a and the predefined monitoring position 310e are defined to monitor pressure while the rest of the predefined monitoring positions 310b-310d are defined to monitor temperature. In the example of **FIG. 3b,** only the predefined monitoring position 3 10e is defined to monitor pressure and the rest of the monitoring positions 3 10a-3 10d are defined to monitor temperature. **FIG. 3c** shows that all the monitoring positions 3 10a-3 10e are defined to detect temperature, and in this example, the multi-parameter sensing film 300 may be used as a temperature sensor. **FIG. 3d** shows that all the monitoring positions 310a-310e are defined to detect pressure, and in this example, the multi-parameter sensing film 300 may be used as a pressure sensor.

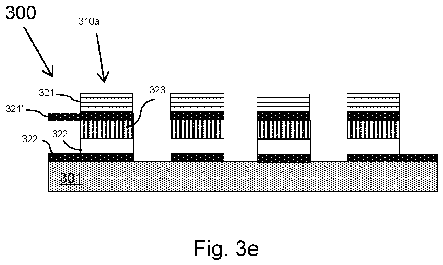

In some other examples, it may also be possible to detect both temperature and pressure at the same monitoring position 310a-310d. In these examples, as presented in **FIG. 3e,** for the monitoring positions 3302a-302e that are defined to monitor both temperature and pressure, the sensing elements 310a-310d are formed by two layers 321, 322 of the single one responsive material arranged on top of each other, and an additional insulation layer 323 may be arranged to be sandwiched between the two layers 321, 322 of the responsive material. Purely by way of example, the layer 321 may be configured to detect pressure, and the bottom layer 322 may be configured to detect temperature at the same monitoring position. Moreover, each one of the layers 321 322 may be provided with its own monitoring circuit 321' 322'.

Using the multi-parameter sensing film 300 illustrated in FIGS. 3a-3d, it may be possible to define whether to monitor pressure, or temperature or to monitor both pressure and temperature at each monitoring position 3 10a-310e. As such, the method may further comprise:

> **S3-1:** defining, by the processing circuitry 402, the operating parameter(s) to be monitored at each monitoring position 3 10a-310e, and

> **S3-2:** converting, by the processing circuitry 402, the electrical resistance detected at each monitoring position 310a-310e to the defined operating parameter value(s).

For different electrical devices, the monitoring of temperature and pressure can vary significantly based on the various factors, for example applications of the electrical devices and/or operational conditions. The significance of monitoring temperature might be vital in certain regions of the electrical device, while pressure measurement may take precedence elsewhere. Therefore, it may be advantageous to define which operating parameter(s) to be monitored at each monitoring position 302a-302e, thereby to allow for the precise delineation of areas of interest, enabling the tailored selection of parameters for monitoring at these specific points.

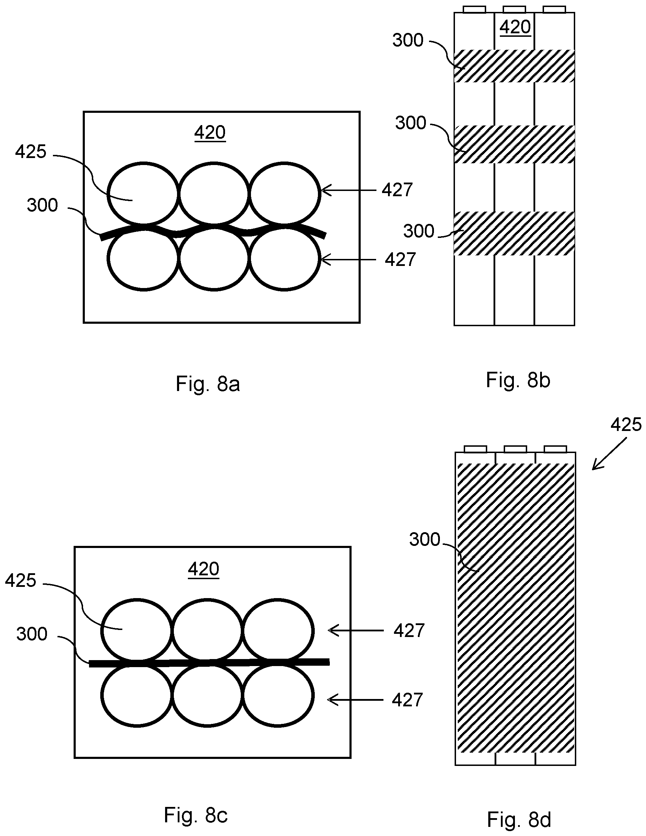

In some examples, the electrical device is a battery cell comprised in a battery system 450 of a vehicle 100, such as the vehicle 100 shown in **FIG. 8,** In the shown example, the battery system 450 further comprises a battery module 420, which my in turn comprises a plurality of battery cells, and a battery management unit 400, configured to monitor the more than one operating parameter of the battery cell by using information of the electrical resistance detected at the predefined monitoring positions 3 10a-310e. In these examples, the method may further comprise:

- in response to the determined more than one operating parameter being higher than an upper threshold level and/or being lower than a lower threshold level, issuing a warning signal, by a processing circuit 402 of the battery management unit 400, to a vehicle electronic control unit (ECU) 106.

In some examples, the warning signal may be issued when the temperature and/or the pressure at one predetermined monitoring position is higher than a threshold level. In other words, the warning signal may be initiated whenever there is a hotspot detected or a sudden spike in pressure at one location. In some other examples, the warning signal may be issued when the temperature and/or the pressure at a number of monitoring positions is higher than a threshold level. In these examples, the threshold level may vary among various monitoring positions, which may allow for dynamic adaptation, as the threshold levels can be tailored to each monitoring position, enhancing the precision of the system's warnings.

After the warning signal has been issued to the vehicle ECU 106, a suitable action may be triggered by the ECU 106. Purely by way of example, when the warning signal is related to temperature issues, a cooling action to cool the battery module 420 may be triggered accordingly. Moreover, when the warning signal is related to pressure issue, potentially signaling cell swelling, the ECU 106 may activate a ventilation process to safely release accumulated gases. By issuing the warning signal related to pressure issue, it may allow for early detection before cell venting, mechanical parts damage by severe deformation due to increased swelling force, etc. A user may receive an alarm before it happens and go to workshop. If there is cell venting, hazardous gases e.g. hydrogen, hydrocarbons, hydrogen fluoride, carbon oxides, etc. could be released. This gas release may be prevented by early detection since cell inner pressure increase by gas evolution would result in the increase in swelling force of the cell and the swelling force increase could be monitored by pressure increase. Furthermore, when the warning is related to pressure issue or both issues, an action for disconnecting the battery module 420 may be initiated.

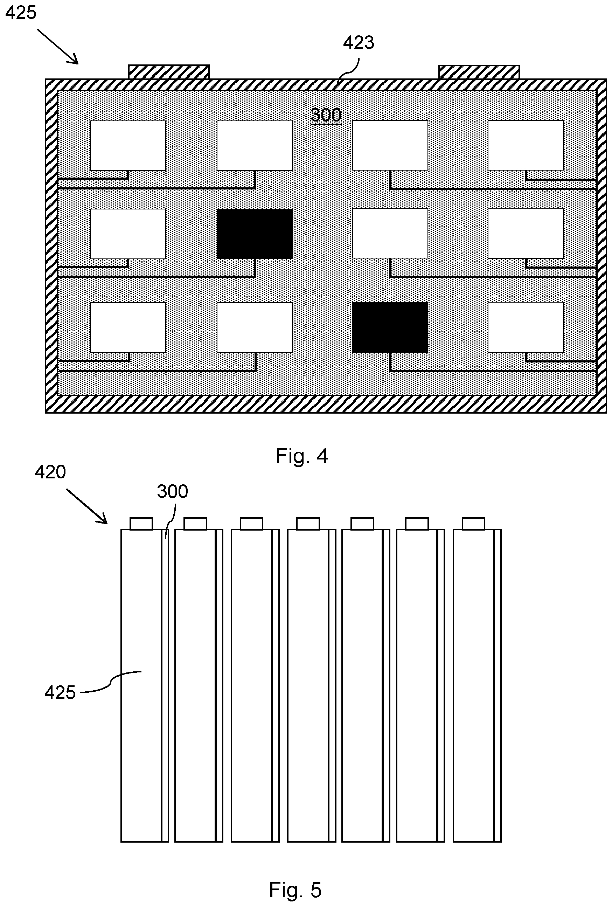

The present disclosure also relates to a battery cell **FIG. 4** shows a front view of a battery cell 425 which is exemplified by a prismatic battery cell 425 and **FIG. 5** shows a side view of a battery module 420 comprising a plurality of battery cells 405 of **FIG. 4.**

In the illustrated example , the battery cell 425 comprises at least one surface 423. The surface may be an outer surface 423 on a front side of the battery cell 425, as shown in **FIG. 4.** The battery cell 425 further comprises one or more multi-parameter sensing films 300 arranged to be abutted against the surface 423 of the battery cell 425, the multi-parameter sensing film 300 at least partially or fully covering the surface 423 of the battery cell 425. The multi-parameter sensing film 300 may be any one of the films as exemplified by **FIG. 1** or **FIGS. 3a-3d.** Using the **FIGS. 3a-3d** multi-parameter sensing film 300 as examples, the film 300 comprises:

- a substrate 301,
- one or more sensing elements 310a-310e arranged on the substrate 301, wherein the one or more sensing elements 3 10a-310e are formed by one single responsive material which is configured to exhibit changes in electrical resistance in response to changes in more than one operating parameter of the battery cells 425, and wherein the more than one operating parameter is temperature and pressure,
- a plurality of monitoring circuits 304a-304d arranged at predefined monitoring positions 302a-302e that are spaced apart from each other over the substrate 301, the monitoring circuits 302a-302d being configured to monitor the electrical resistance of the responsive material at monitoring positions 302a-302e,

Purely by way of example, the one single responsive material comprises one of the following: graphene, graphene oxides, carbon nano tubes, carbon nano fibers, graphite embedded polydimethylsiloxane, or poly(3,4-ethylenedioxythiophene) polystyrene sulfonate.

FIG. 5 illustrates a battery module 420 comprising a plurality of battery cells 425. The battery cells 405 are stacked adjacent to one another in a side-by-side configuration, and the multi-parameter sensing film 300 is sandwiched between the adjacent battery cells 425. With this configuration, the temperature and pressure at local areas on the surface 423 of each battery cell 425 is monitored, providing more comprehensive information for assessing the overall health state of the battery module 420.

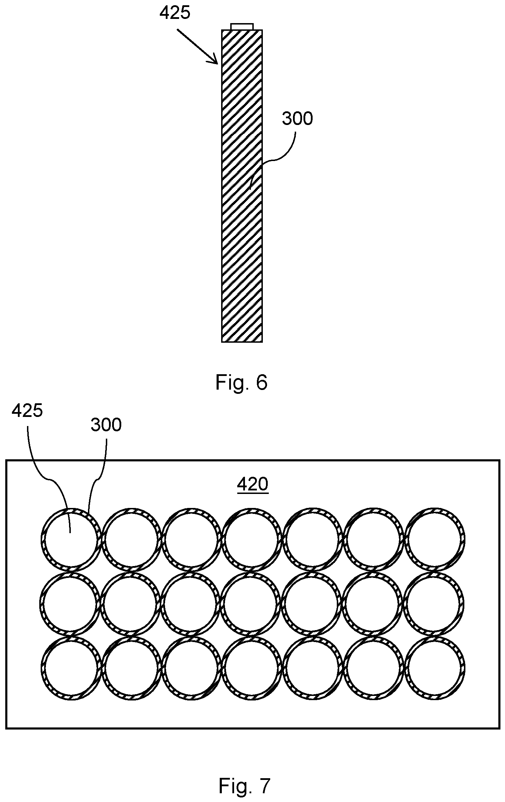

FIG. 6 shows a side view of another example of a battery cell 425 which is exemplified by a cylindrical battery cell, where the outer surface (not shown) of the battery cell 425 is covered by the multi-parameter sensing film 300. FIG. 7 shows a top view of a battery module 420 comprising a plurality of battery cells 425 of FIG 6. In the illustrated example, the cylindrical battery cells 425 are stacked adjacent to one another in a side-by-side configuration to form one or more battery array 427 in a row-like arrangement, where each battery cell 425 is provided with one multi-parameter sensing film 300. With this configuration, the temperature and pressure at local area on the surface 423 of each battery cell 425 is monitored, providing more comprehensive information for assessing the overall health state of the battery module 420. In some other examples, the multi-parameter sensing film 300 may be arranged to be wrapped around the battery stack 427 in a way that the sensing film 300 at least partially covers each one battery cell 425 of one battery array 427, which are illustrated by **FIGS.8a-8d.**

Irrespective of the battery cell 405 being prismatic or being cylindrical, the multi-parameter sensing films 300 is arranged to be abutted against the surface 423 of the battery cell 425, in a way that the multi-parameter sensing film 300 at least partially or fully covers the surface 423 of the battery cell 425. As such, by monitoring electrical resistance at the monitoring positions 302a-302e, it may be possible to obtain a temperature and pressure distribution profile across the entire sensing film 300, if each one of the monitoring positions are defined to monitor both temperature and pressure. It, in turn, may reflect the temperature and pressure distribution profile across the mirroring surface 423 of the battery cell 425.

In the illustrated examples of the multi-parameter sensing film 300 shown in **FIGS. 3a-3d,** the sensing elements 310a-3 10e are formed at the predefined monitoring positions 302a-302e and each sensing element 310a-310e has a defined shape with a defined dimension. Generally, battery cells may vary in sizes and/or shapes, depending on the intended applications. By allowing the shape and dimension of each sensing element 310a-310e to vary, the multi-parameter sensing film 300 may adapt to the specific characteristics of different battery cells. While the illustration depicts each sensing element 310a-310e distributed evenly across the substrate 301, it is conceivable that these sensing elements 310a-310e may adopt diverse shapes and be distributed unevenly on the substrate 301 as well.

In some examples, each monitoring position 302a-302e is defined whether to monitor temperature and/or to monitor pressure. The significance of monitoring temperature might be vital in certain regions of the battery cell 425, while pressure measurement may take precedence elsewhere. By defining the operating parameter(s) to be monitored at each monitoring position 302a-302e, it may allow for the precise delineation of areas of interest, enabling the tailored selection of parameters for monitoring at these specific points.

In some examples, the battery module 420 is comprised in a battery system 450 of a vehicle 100 shown in **FIG. 8,** The battery system 450 may further comprise a battery management unit 400 which comprises processing circuitry 402 configured to performed the method discussed above.. Those of ordinary skill in the art will appreciate that any suitable devices may be provided to evaluate the electric resistance detected by the monitoring circuits 204a-204d, 304a-304d. When it is detected that the parameters are higher than an upper threshold level and/or is lower than a lower threshold level, a warning signal may be sent to vehicle ECU 406 and a suitable action may be triggered accordingly.

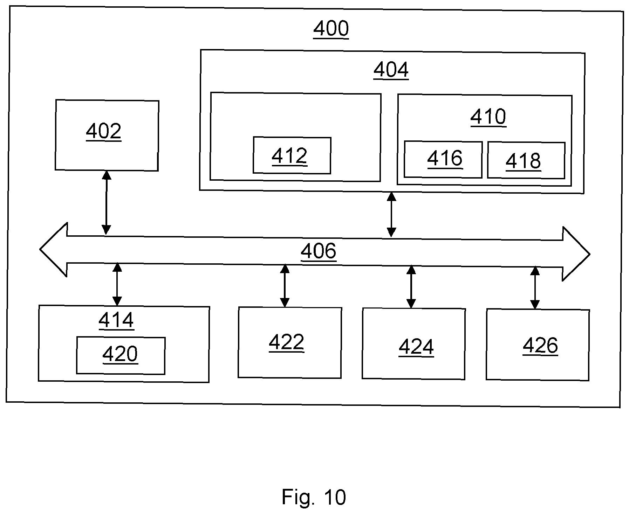

The battery management unit 400 may be seen as a computer system 400, as presented in **FIG. 10.** More specifically, the computer system **400** is adapted to execute instructions from a computer-readable medium to perform these and/or any of the functions or processing described herein. The computer system **400** may be connected (e.g., networked) to other machines in a LAN, an intranet, an extranet, or the Internet. While only a single device is illustrated, the computer system **400** may include any collection of devices that individually or jointly execute a set (or multiple sets) of instructions to perform any one or more of the methodologies discussed herein. Accordingly, any reference in the disclosure and/or claims to a computer system, computing system, computer device, computing device, control system, control unit, electronic control unit (ECU), processor device, processing circuitry, etc., includes reference to one or more such devices to individually or jointly execute a set (or multiple sets) of instructions to perform any one or more of the methodologies discussed herein. For example, control system may include a single control unit or a plurality of control units connected or otherwise communicatively coupled to each other, such that any performed function may be distributed between the control units as desired. Further, such devices may communicate with each other or other devices by various system architectures, such as directly or via a Controller Area Network (CAN) bus, etc.

The computer system **400** may comprise at least one computing device or electronic device capable of including firmware, hardware, and/or executing software instructions to implement the functionality described herein. The computer system **400** may include processing circuitry **402** (e.g., processing circuitry including one or more processor devices or control units), a memory **404,** and a system bus **406**. The computer system **400** may include at least one computing device having the processing circuitry **402**. The system bus **406** provides an interface for system components including, but not limited to, the memory **404** and the processing circuitry **402**. The processing circuitry **402** may include any number of hardware components for conducting data or signal processing or for executing computer code stored in memory **404.** The processing circuitry **402** may, for example, include a general-purpose processor, an application specific processor, a Digital Signal Processor (DSP), an Application Specific Integrated Circuit (ASIC), a Field Programmable Gate Array (FPGA), a circuit containing processing components, a group of distributed processing components, a group of distributed computers configured for processing, or other programmable logic device, discrete gate or transistor logic, discrete hardware components, or any combination thereof designed to perform the functions described herein. The processing circuitry **402** may further include computer executable code that controls operation of the programmable device.

The system bus **406** may be any of several types of bus structures that may further interconnect to a memory bus (with or without a memory controller), a peripheral bus, and/or a local bus using any of a variety of bus architectures. The memory **404** may be one or more devices for storing data and/or computer code for completing or facilitating methods described herein. The memory **404** may include database components, object code components, script components, or other types of information structure for supporting the various activities herein. Any distributed or local memory device may be utilized with the systems and methods of this description. The memory **404** may be communicably connected to the processing circuitry **402** (e.g., via a circuit or any other wired, wireless, or network connection) and may include computer code for executing one or more processes described herein. The memory **404** may include non-volatile memory **408** (e.g., read-only memory (ROM), erasable programmable read-only memory (EPROM), electrically erasable programmable read-only memory (EEPROM), etc.), and volatile memory **410** (e.g., random-access memory (RAM)), or any other medium which can be used to carry or store desired program code in the form of machine-executable instructions or data structures and which can be accessed by a computer or other machine with processing circuitry **402**. A basic input/output system (BIOS) **412** may be stored in the non-volatile memory **408** and can include the basic routines that help to transfer information between elements within the computer system **400.**

The computer system **400** may further include or be coupled to a non-transitory computer-readable storage medium such as the storage device **414,** which may comprise, for example, an internal or external hard disk drive (HDD) (e.g., enhanced integrated drive electronics (EIDE) or serial advanced technology attachment (SATA)), HDD (e.g., EIDE or SATA) for storage, flash memory, or the like. The storage device **414** and other drives associated with computer-readable media and computer-usable media may provide non-volatile storage of data, data structures, computer-executable instructions, and the like.

Computer-code which is hard or soft coded may be provided in the form of one or more modules. The module(s) can be implemented as software and/or hard-coded in circuitry to implement the functionality described herein in whole or in part. The modules may be stored in the storage device **414** and/or in the volatile memory **410,** which may include an operating system **416** and/or one or more program modules **418**. All or a portion of the examples disclosed herein may be implemented as a computer program **420** stored on a transitory or non-transitory computer-usable or computer-readable storage medium (e.g., single medium or multiple media), such as the storage device **414,** which includes complex programming instructions (e.g., complex computer-readable program code) to cause the processing circuitry **402** to carry out actions described herein. Thus, the computer-readable program code of the computer program **420** can comprise software instructions for implementing the functionality of the examples described herein when executed by the processing circuitry **402**. In some examples, the storage device **414** may be a computer program product (e.g., readable storage medium) storing the computer program **420** thereon, where at least a portion of a computer program **420** may be loadable (e.g., into a processor) for implementing the functionality of the examples described herein when executed by the processing circuitry **402**. The processing circuitry **402** may serve as a controller or control system for the computer system **400** that is to implement the functionality described herein.

The computer system **400** may include an input device interface **422** configured to receive input and selections to be communicated to the computer system **400** when executing instructions, such as from a keyboard, mouse, touch-sensitive surface, etc. Such input devices may be connected to the processing circuitry **402** through the input device interface **422** coupled to the system bus **406** but can be connected through other interfaces, such as a parallel port, an Institute of Electrical and Electronic Engineers (IEEE) 1394 serial port, a Universal Serial Bus (USB) port, an IR interface, and the like. The computer system **400** may include an output device interface **424** configured to forward output, such as to a display, a video display unit (e.g., a liquid crystal display (LCD) or a cathode ray tube (CRT)). The computer system **400** may include a communications interface **426** suitable for communicating with a network as appropriate or desired.

The operational actions described in any of the exemplary aspects herein are described to provide examples and discussion. The actions may be performed by hardware components, may be embodied in machine-executable instructions to cause a processor to perform the actions, or may be performed by a combination of hardware and software.

Although a specific order of method actions may be shown or described, the order of the actions may differ. In addition, two or more actions may be performed concurrently or with partial concurrence.

Moreover, the present disclosure may be exemplified by any one of the below examples and combination of examples.

**Example 1:** A computer-implemented method of determining one or more operating parameters of an electrical device comprising at least one surface by means of a multi-parameter sensing film 200, 300, the sensing film being arranged to be abutted against the surface of the electrical device, wherein the one or more operating parameters are temperature and/or pressure, the film comprising:

- a substrate 201,301,
- one or more sensing elements 210, 310a-310d arranged on the substrate 201, 301, wherein the one or more sensing elements 210, 310a-310d are formed by at least one responsive material which is configured to exhibit changes in electrical resistance in response to changes in the operating parameters,
- a plurality of monitoring circuits 204a-204d, 304a-304d arranged at predefined monitoring positions 202a-204d, 302a-302d that are spaced apart from each other over the substrate 201,301, the monitoring circuits 204a-204d, 304a-304d being configured to monitor the electrical resistance of the at least one responsive material at monitoring positions 202a-204d, 302a-302d,

the method comprising:

- detecting S1, by processing circuitry 402 of a computer system 400, electrical resistances of the at least one responsive material at monitoring positions 202a-204d, 302a-302d, and
- determining S2, by the processing circuitry 402, the one or more operating parameters at the predefined monitoring positions 202a-204d, 302a-302d by using information of the detected electrical resistances.

**Example 2:** the method of Example 1, wherein the responsive material comprises at least one of a negative temperature coefficient material, a positive temperature coefficient material, and/or a metal-based material.

**Example 3:** the method of Example 2, wherein the negative temperature coefficient material is a carbon-based material.

**Example 4:** the method of Example 3, wherein the carbon-based material comprises graphene.

**Example 5:** The method according to any one of the preceding examples, further comprising:

- determining S3, by processing circuitry 402, the one or more operating parameters by converting the electrical resistances detected at said monitoring positions 202a-204d, 302a-302d to the corresponding parameters.

**Example 6:** The method according to Example 5, further comprising:

- defining S3-1, by processing circuitry 402, the operating parameter(s) to be monitored at each predefined monitoring position 202a-204d, 302a-302d, and
- converting S3-2, by processing circuitry 402, the electrical resistance detected at each predefined monitoring position 202a-204d, 302a-302d to the defined operating parameter(s).

**Example 7:** The method according to any one of the examples, wherein the electrical device is a battery module 420 comprised in a battery system 450 of a vehicle 100, the battery system 450 further comprising a battery management unit 400 configured to monitor the one or more operating parameters of the battery module 420 by using information of the electrical resistances detected at monitoring positions 202a-204d, 302a-302, the method further comprising:

- in response to the determined one or more operating parameters being higher than a threshold level and/or being lower than a threshold level, issuing, by processing circuitry 402 of the battery management unit 400, a warning signal to a vehicle electronic control unit 406.

**Example 8:** A battery module 420 comprising:

- one or more battery cells 405, each battery cell comprising at least one surface 423,
- one or more multi-parameter sensing films 200, 300 arranged to be abutted against said surface 423 of said battery cell 425, said film at least partially or fully covering said surface 423 of said battery cell 425,

wherein the multi-parameter sensing film 200, 300 comprises:

- a substrate 201, 301,
- one or more sensing elements 210, 310a-310d arranged on said substrate 201, 301, wherein said one or more sensing elements 210, 310a-310d are formed by at least one responsive material which is configured to exhibit changes in electrical resistance in response to changes in one or more operating parameters of the battery cells, wherein the one or more operating parameters are temperature and/or pressure,
- a plurality of monitoring circuits 204a-204d, 304a-304d arranged at predefined monitoring positions 202a-204d, 302a-302d that are spaced apart from each other over the substrate 201, 301, said monitoring circuits 204a-204d, 304a-304d being configured to monitor the electrical resistance of said at least one responsive material at the predefined monitoring positions,
- wherein the responsive material is a carbon-based material and/or a metal-based material.

**Example 9:** The battery module 420 according to Example 8, wherein said sensing elements 210, 310a-310d are formed at the predefined monitoring positions 202a-204d, 302a-302d.

**Example 10:** The battery module 420 according to Example 7 or Example 8, wherein each sensing element 210, 310a-310d has a defined shape with a defined dimension.

**Example 11:** The battery module 420 according to any one of Example 8-Example 10, wherein the carbon-based material comprises graphene.

**Example 12:** The battery module 420 according to any one of Example 8-Example 11, wherein each predefined monitoring position 202a-204d, 302a-302d is defined whether to monitor temperature and/or to monitor pressure.

**Example 13:** The battery module according to Example 12, wherein the following material is arranged to be printed on the monitoring positions 202a-204d, 302a-302d that are defined to monitor the temperature: carbonaceous based materials, metallic based materials and/or polymer-based materials.

**Example 14:** The battery module according to Example 11 or Example 12, wherein the following material is arranged to be printed to the monitoring positions 202a-204d, 302a-302d that are defined to monitor the pressure: carbonaceous based materials, metal oxides-based materials, metal sulfides-based materials and/or polymer-based materials.

**Example 15:** The battery module according to any one of Example 8-Example 14, wherein the substrate 201, 301 is formed by a polymer-based material.

**Example 16:** The battery module 420 according to any one of Example 8-Example 15, wherein said battery cells 405 are cylindrical batteries, and wherein the cylindrical batteries are stacked adjacent to one another in a side-by-side configuration to form one or more battery stack 407.

**Example 17:** The battery module 420 according to Example 16, wherein one multi-parameter sensing film 200 300 is arranged to be wrapped around said battery stack 407, such that said sensing film 200 300 at least partially covers each battery cell 425 of the battery stack 407, or wherein each battery cell 425 is provided with one multi-parameter sensing film 200, 300.

**Example 18:** The battery module 420 according to any one of Example 8-Example 15, wherein said battery cells 425 are prismatic batteries or pouch batteries, and wherein said battery cells 425 are stacked adjacent to one another in a side-by-side configuration.

**Example 19:** The battery module 420 according to Example 18, wherein the multi-parameter sensing film 200, 300 is sandwiched between the adjacent battery cells 425.

**Example 20:** A battery system 450 comprising a battery module according to any one of Example 8-Example 19, and a battery management unit 400 configured to monitor the one or more operating parameters at defined areas of the at least one surface 423 of the battery cell 425 by using information of the electrical resistances detected at monitoring positions 202a-204d, 302a-302d.

**Example 21:** A vehicle 100 comprising a battery module 420 according to any one of Example 8- Example 1 9 and/or a battery system 450 according to Example 20.

Moreover, the present disclosure may be exemplified by any one of the below examples and combination of items.

Item1 A computer-implemented method of determining more than one operating parameter of an electrical device comprising at least one surface by means of a multi-parameter sensing film (200, 300), said film being arranged to be abutted against said surface of said electrical device, wherein the more than one operating parameter is temperature and pressure, said film comprising:

- a substrate (201,301),
- one or more sensing elements (210, 310a-310d) arranged on said substrate (201, 301), wherein said one or more sensing elements (210, 3 10a-3 10d) are formed by one single responsive material which is configured to exhibit changes in electrical resistance in response to changes in said operating parameters,

- a plurality of monitoring circuits (204a-204d, 304a-304d) arranged at predefined monitoring positions (202a-204d, 302a-302d) that are spaced apart from each other over said substrate (201,301), said monitoring circuits (204a-204d, 304a-304d) being configured to monitor the electrical resistance of said one single responsive material at said predefined monitoring positions (202a-204d, 302a-302d),

the method comprising:

- detecting (S1), by processing circuitry (402) of a computer system (400), electrical resistance of said responsive material at monitoring positions (202a-204d, 302a-302d), and

- determining (S2), by the processing circuitry (402), said operating parameters at said monitoring positions (202a-204d, 302a-302d) by using information of the detected electrical resistance.

Item2 The method according to Item 1, wherein the one single responsive material comprises one of the following: graphene, graphene oxides, carbon nano tubes, carbon nano fibers, graphite embedded polydimethylsiloxane, or poly (3,4-ethylenedioxythiophene) polystyrene sulfonate.

Item3 The method according to any one of Items 1-2, further comprising:

- determining (S3), by the processing circuitry (402), the operating parameters by converting the electrical resistance detected at said predefined monitoring positions (202a-204d, 302a-302d) to the operating parameter values.

Item4 The method according to Item 3, further comprising:

- defining (S3-1), by the processing circuitry (402), the operating parameter(s) to be monitored at each monitoring position (202a-204d, 302a-302d), and
- converting (S3-2), by the processing circuitry (402), the electrical resistance detected at each monitoring position (202a-204d, 302a-302d) to the defined operating parameter value(s).

Item5 The method according to any one of the preceding Items, wherein the electrical device is a battery cell (405) comprised in a battery system (450) of a vehicle (100), the battery system (450) further comprising a battery management unit (400) configured to monitor the operating parameters of the battery cell (425) by using information of the electrical resistance detected at the predefined monitoring positions (202a-204d, 302a-302d), the method further comprising:

- in response to the determined operating parameters being higher than an upper threshold level or being lower than a lower threshold level, issuing, by the processing circuitry (402) of the battery management unit (400), a warning signal to a vehicle electronic control unit (106).

Item6 A battery cell (425) comprising:

- at least one surface (423),
- one or more multi-parameter sensing films (200, 300) arranged to be abutted against said surface (423) of said battery cell (425), said film at least partially or fully covering said surface (423) of said battery cell (425),

wherein the multi-parameter sensing film (200, 300) comprises:

- a substrate (201, 301),
- one or more sensing elements (210, 310a-310d) arranged on said substrate (201, 301), wherein said one or more sensing elements (210, 3 10a-3 10d) are formed by one single responsive material which is configured to exhibit changes in electrical resistance in response to changes in more than one operating parameter of the battery cells, wherein the more than one operating parameter is temperature and pressure,
- a plurality of monitoring circuits (204a-204d, 304a-304d) arranged at predefined monitoring positions (202a-204d, 302a-302d) that are spaced apart from each other over the substrate (201, 301), said monitoring circuits (204a-204d, 304a-304d) being configured to monitor the electrical resistance of said responsive material at said predefined monitoring positions (202a-204d, 302a-302d).

Item7 The battery cell (425) according to Item 6, wherein the one single responsive material comprises one of the following: graphene, graphene oxides, carbon nano tubes, carbon nano fibers, graphite embedded polydimethylsiloxane, or poly(3,4-ethylenedioxythiophene) polystyrene sulfonate.

Item8 The battery cell (425) according to any one of Items 6-7, wherein said sensing elements (210, 310a-310d) are formed at the predefined monitoring positions (202a-204d, 302a-302d).

Item9 The battery cell (425) according to any one of Items 6-8, wherein each sensing element (210, 310a-310d) has a defined shape with a defined dimension.

Item10 The battery cell (425) according to any one of Items 6-9, wherein each monitoring position (202a-204d, 302a-302d) is defined to monitor one of the following: temperature, pressure, or both of temperature and pressure.

Item 11 The battery cell (425) according to Item 10, wherein for the monitoring positions (202a-204d, 302a-302d) that are defined to monitor both temperature and pressure, the sensing elements are formed by two layers of the single one responsive material arranged on top of each other.

Item12 The battery cell (425) according to any one of Items 6-11, wherein the substrate (201, 301) is formed by a polymer-based material.

Item13 The battery cell (425) according to any one of Items 6-12, wherein the substrate (201, 301) has a thickness less than 1 mm.

Item14 A battery module (420) comprising a plurality of battery cells (425) according to any one of Items 6-13.

Item15 A battery system (450) comprising the battery module (420) according to Item 15, and a battery management unit (400) configured to monitor the more than one operating parameter at defined areas of the at least one surface (423) of the battery cell (425) by using information of the electrical resistance detected at said predefined monitoring positions (202a-204d, 302a-302d).

Item16 A vehicle (100) comprising a battery module (420) according to Item 15 and/or a battery system (450) according to Item 16.

The terminology used herein is for the purpose of describing particular aspects only and is not intended to be limiting of the disclosure. As used herein, the singular forms "a," "an," and "the" are intended to include the plural forms as well, unless the context clearly indicates otherwise. As used herein, the term "and/or" includes any and all combinations of one or more of the associated listed items. It will be further understood that the terms "comprises," "comprising," "includes," and/or "including" when used herein specify the presence of stated features, integers, actions, steps, operations, elements, and/or components, but do not preclude the presence or addition of one or more other features, integers, actions, steps, operations, elements, components, and/or groups thereof.

It will be understood that, although the terms first, second, etc., may be used herein to describe various elements, these elements should not be limited by these terms. These terms are only used to distinguish one element from another. For example, a first element could be termed a second element, and, similarly, a second element could be termed a first element without departing from the scope of the present disclosure.

Relative terms such as "below" or "above" or "upper" or "lower" or "horizontal" or "vertical" may be used herein to describe a relationship of one element to another element as illustrated in the Figures. It will be understood that these terms and those discussed above are intended to encompass different orientations of the device in addition to the orientation depicted in the Figures. It will be understood that when an element is referred to as being "connected" or "coupled" to another element, it can be directly connected or coupled to the other element, or intervening elements may be present. In contrast, when an element is referred to as being "directly connected" or "directly coupled" to another element, there are no intervening elements present.

Unless otherwise defined, all terms (including technical and scientific terms) used herein have the same meaning as commonly understood by one of ordinary skill in the art to which this disclosure belongs. It will be further understood that terms used herein should be interpreted as having a meaning consistent with their meaning in the context of this specification and the relevant art and will not be interpreted in an idealized or overly formal sense unless expressly so defined herein.

It is to be understood that the present disclosure is not limited to the aspects described above and illustrated in the drawings; rather, the skilled person will recognize that many changes and modifications may be made within the scope of the present disclosure and appended claims. In the drawings and specification, there have been disclosed aspects for purposes of illustration only and not for purposes of limitation, the scope of the disclosure being set forth in the following claims.

**Claims**

1. A computer-implemented method of determining more than one operating parameter of an electrical device comprising at least one surface by means of a multi-parameter sensing film (200, 300), said film being arranged to be abutted against said surface of said electrical device, wherein the more than one operating parameter is temperature and pressure, said film comprising:

    - a substrate (201,301),
    - one or more sensing elements (210, 310a-310d) arranged on said substrate (201, 301), wherein said one or more sensing elements (210, 3 10a-310d) are formed by one single responsive material which is configured to exhibit changes in electrical resistance in response to changes in said operating parameters,
    - a plurality of monitoring circuits (204a-204d, 304a-304d) arranged at predefined monitoring positions (202a-204d, 302a-302d) that are spaced apart from each other over said substrate (201,301), said monitoring circuits (204a-204d, 304a-304d) being configured to monitor the electrical resistance of said one single responsive material at said predefined monitoring positions (202a-204d, 302a-302d),

    the method comprising:

    - detecting (S1), by processing circuitry (402) of a computer system (400), electrical resistance of said responsive material at monitoring positions (202a-204d, 302a-302d), and
    - determining (S2), by the processing circuitry (402), said operating parameters at said monitoring positions (202a-204d, 302a-302d) by using information of the detected electrical resistance.

2. The method according to claim 1, wherein the one single responsive material comprises one of the following: graphene, graphene oxides, carbon nano tubes, carbon nano fibers, graphite embedded polydimethylsiloxane, or poly (3,4-ethylenedioxythiophene) polystyrene sulfonate.

3. The method according to any one of claims 1-2, further comprising:

    - determining (S3), by the processing circuitry (402), the operating parameters by converting the electrical resistance detected at said predefined monitoring positions (202a-204d, 302a-302d) to the operating parameter values.

4. The method according to claim 3, further comprising:

    - defining (S3-1), by the processing circuitry (402), the operating parameter(s) to be monitored at each monitoring position (202a-204d, 302a-302d), and
    - converting (S3-2), by the processing circuitry (402), the electrical resistance detected at each monitoring position (202a-204d, 302a-302d) to the defined operating parameter value(s).

5. The method according to any one of the preceding claims, wherein the electrical device is a battery cell (405) comprised in a battery system (450) of a vehicle (100), the battery system (450) further comprising a battery management unit (400) configured to monitor the operating parameters of the battery cell (425) by using information of the electrical resistance detected at the predefined monitoring positions (202a-204d, 302a-302d), the method further comprising:

    - in response to the determined operating parameters being higher than an upper threshold level or being lower than a lower threshold level, issuing, by the processing circuitry (402) of the battery management unit (400), a warning signal to a vehicle electronic control unit (106).

6. A battery cell (425) comprising:

    - at least one surface (423),

- one or more multi-parameter sensing films (200, 300) arranged to be abutted against said surface (423) of said battery cell (425), said film at least partially or fully covering said surface (423) of said battery cell (425),

wherein the multi-parameter sensing film (200, 300) comprises:

- a substrate (201, 301),
- one or more sensing elements (210, 310a-310d) arranged on said substrate (201, 301), wherein said one or more sensing elements (210, 3 10a-3 10d) are formed by one single responsive material which is configured to exhibit changes in electrical resistance in response to changes in more than one operating parameter of the battery cells, wherein the more than one operating parameter is temperature and pressure,
- a plurality of monitoring circuits (204a-204d, 304a-304d) arranged at predefined monitoring positions (202a-204d, 302a-302d) that are spaced apart from each other over the substrate (201, 301), said monitoring circuits (204a-204d, 304a-304d) being configured to monitor the electrical resistance of said responsive material at said predefined monitoring positions (202a-204d, 302a-302d).

7.   The battery cell (425) according to claim 6, wherein the one single responsive material comprises one of the following: graphene, graphene oxides, carbon nano tubes, carbon nano fibers, graphite embedded polydimethylsiloxane, or poly(3,4-ethylenedioxythiophene) polystyrene sulfonate.

8.   The battery cell (425) according to any one of claims 6-7, wherein said sensing elements (210, 310a-310d) are formed at the predefined monitoring positions (202a-204d, 302a-302d).

9.   The battery cell (425) according to any one of claims 6-8, wherein each monitoring position (202a-204d, 302a-302d) is defined to monitor one of the following: temperature, pressure, or both of temperature and pressure.

10.  The battery cell (425) according to claim 9, wherein for the monitoring positions (202a-204d, 302a-302d) that are defined to monitor both temperature and pressure, the sensing elements (210, 310a-310d) are formed by two layers (321, 322) of the single one responsive material arranged on top of each other.

11.  The battery cell (425) according to any one of claims 6-10, wherein the substrate (201, 301) is formed by a polymer-based material.

12.  The battery cell (425) according to any one of claims 6-11, wherein the substrate (201, 301) has a thickness less than 1 mm.

13.  A battery module (420) comprising a plurality of battery cells (425) according to any one of claims 6-12.

14.  A battery system (450) comprising the battery module (420) according to claim 13, and a battery management unit (400) configured to monitor the more than one operating parameter at defined areas of the at least one surface (423) of the battery cell (425) by using information of the electrical resistance detected at said predefined monitoring positions (202a-204d, 302a-302d).

15.  A vehicle (100) comprising a battery module (420) according to claim 13 and/or a battery system (450) according to claim 14.

Fig. 1

S1

S2

S3-1

S3-2

S3

Fig. 2

Fig. 3a

Fig. 3b

300

310b,302b      310c,302c    310d,302d

301

310a,302a

304a

304b

304d

304c

Fig. 3c

300

310b,302b      310c,302c    310d,302d

301

310a,302a

304a

304b

304d

304c

Fig. 3d

Fig. 3e

Fig. 4

Fig. 5

425

300

Fig. 6

425

300

420

Fig. 7

Fig. 8a

Fig. 8b

Fig. 8c

Fig. 8d

Fig. 9

Fig. 10

| | Europäisches Patentamt European Patent Office Office européen des brevets | **EUROPEAN SEARCH REPORT** | **Application Number** EP 24 21 5749 |

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | EP 3 525 279 A1 (TNO [NL]) 14 August 2019 (2019-08-14) | 1-9, 11-15 | INV. H01M10/42 |
| A | * paragraphs [0013], [0072] - [0082], [0088] - [0090], [0093], [0095], [0102], [0106] * * claims 1-3,6 * * figures 1,4 * | 10 | H01M10/48 G01K7/00 G01L1/18 |
| X | CN 114 295 160 A (EIGHTEENTH RESEARCH INSTITUTE OF CHINESE ELECTRONIC SCIENCE AND TECH G) 8 April 2022 (2022-04-08) | 1-9, 11-15 | |
| A | * sections "Background technique" and parts related to fig. 1 * * claims 1,3,9 * * figure 1 * | 10 | |
| X | BREE GERARD ET AL.: "Monitoring state of charge and volume expansion in lithium-ion batteries: an approach using surface mounted thin-film graphene sensors", RSC ADVANCES, vol. 13, 1 March 2023 (2023-03-01), pages 7045-7054, XP002810361, DOI: HTTPS://DOI.ORG/10.1039/D2RA07572E * setions 2.1, 2.2 and 3.1 * | 6-9,11, 12 | |
| A,D | JIRÍ STULÍK: "Graphene-Based Temperature Sensors-Comparison of the Temperature and Humidity Dependences", NANOMATERIALS, vol. 12, no. 9, 7 May 2022 (2022-05-07), page 1594, XP093168461, ISSN: 2079-4991, DOI: 10.3390/nano12091594 * the whole document * | 1-15 | |

TECHNICAL FIELDS SEARCHED (IPC)

H01M
G01W
G01L
G01K

-/--

The present search report has been drawn up for all claims

| Place of search | Date of completion of the search | Examiner |
|---|---|---|
| The Hague | 20 March 2025 | Järvi, Tommi |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

| | Europäisches Patentamt / European Patent Office / Office européen des brevets | **EUROPEAN SEARCH REPORT** | **Application Number** EP 24 21 5749 |
|---|---|---|---|

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 116 593 059 A (NINGDE CONTEMPORARY AMPEREX TECH CO LTD) 15 August 2023 (2023-08-15) * Description relating to figs. 4 and 5 * * figures 4, 5 * | 1-15 | |
| | ----- | | |
| | | | **TECHNICAL FIELDS SEARCHED (IPC)** |

The present search report has been drawn up for all claims

| Place of search | Date of completion of the search | Examiner |
|---|---|---|
| The Hague | 20 March 2025 | Järvi, Tommi |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

page 2 of 2

## ANNEX TO THE EUROPEAN SEARCH REPORT
## ON EUROPEAN PATENT APPLICATION NO.

EP 24 21 5749

This annex lists the patent family members relating to the patent documents cited in  the above-mentioned European search report.
The members are as contained in the European Patent Office EDP file on
The European Patent Office is in no way liable for these particulars which are merely given for the purpose of information.

20-03-2025

| Patent document cited in search report | | Publication date | Patent family member(s) | | Publication date |
|---|---|---|---|---|---|
| EP 3525279 | A1 | 14-08-2019 | EP | 3525279 A1 | 14-08-2019 |
| | | | TW | 201937803 A | 16-09-2019 |
| | | | WO | 2019156561 A1 | 15-08-2019 |
| CN 114295160 | A | 08-04-2022 | NONE | | |
| CN 116593059 | A | 15-08-2023 | CN | 116593059 A | 15-08-2023 |
| | | | WO | 2025015714 A1 | 23-01-2025 |

EPO FORM P0459

For more details about this annex : see Official Journal of the European Patent Office, No. 12/82

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Non-patent literature cited in the description**

- **SARA S. MECHAEL et al.** *iScience*, 25 June 2021, vol. 24, 102525